(19) **Europäisches Patentamt / European Patent Office / Office européen des brevets**

(11) **EP 4 682 656 A1**

(12) **EUROPÄISCHE PATENTANMELDUNG**

(43) Veröffentlichungstag:
21.01.2026 Patentblatt 2026/04

(21) Anmeldenummer: 25183516.1

(22) Anmeldetag: 18.06.2025

(51) Internationale Patentklassifikation (IPC):
**G05B 19/40** (2006.01) **G05B 19/418** (2006.01)
**H01J 37/30** (2006.01)

(52) Gemeinsame Patentklassifikation (CPC):
**G05B 19/4093; B24B 13/06; G05B 19/41865;**
**H01J 37/3023; H01J 37/304; H01J 37/3056;**
G02B 5/0891; G05B 2219/35215;
G05B 2219/36357; G05B 2219/45096;
G05B 2219/45157; G05B 2219/45199;
G05B 2219/49345; H01J 2237/30483

(84) Benannte Vertragsstaaten:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Benannte Erstreckungsstaaten:
**BA**
Benannte Validierungsstaaten:
**GE KH LA MA MD TN**

(30) Priorität: **15.07.2024 DE 102024206637**

(71) Anmelder: **Carl Zeiss SMT GmbH**
**73447 Oberkochen (DE)**

(72) Erfinder:
• **NIMMER, Max**
**73447 Oberkochen (DE)**
• **PERFAHL, Holger**
**73447 Oberkochen (DE)**
• **PERSCH, Johannes**
**73447 Oberkochen (DE)**
• **VAUTH, Sebastian**
**73447 Oberkochen (DE)**

(74) Vertreter: **Zeuner Summerer Stütz**
**Patent- und Rechtsanwälte**
**Partnerschaft**
**Nußbaumstraße 8**
**80336 München (DE)**

(54) **VORRICHTUNG ZUM VERÄNDERN EINER FORM EINER OBERFLÄCHE EINES OBJEKTS**

(57) Eine Vorrichtung (10) zum Verändern einer Form einer Oberfläche (12) eines Objekts (14) umfasst eine Formmanipulationseinrichtung (16), welche dazu konfiguriert ist, in mindestens zwei Bearbeitungsvorgängen in Abhängigkeit von einer Steuerungsgröße (56) eine Veränderung der Oberfläche des Objekts zu bewirken, wobei mindestens ein Abschnitt der Oberfläche in jedem der Bearbeitungsvorgänge bearbeitet wird. Weiterhin umfasst die Vorrichtung eine Steuerungseinrichtung (50), welche dazu konfiguriert ist, aus einer vorgegebenen Solländerung (52) der Oberflächenform des Objekts eine Vorgabe (56v) für die Steuerungsgröße (56) der Formmanipulationseinrichtung mittels einer Optimierung (60) zu ermitteln, bei der eine Gesamtzeit, welche zur Erzeugung der durch die mindestens zwei Bearbeitungsvorgänge erfolgenden Oberflächenänderung benötigt wird, minimiert wird.

Fig. 1

## Beschreibung

Die vorliegende Anmeldung beansprucht die Priorität der deutschen Patentanmeldung 10 2024 206 637.0 vom 15. Juli 2024. Die gesamte Offenbarung dieser Patentanmeldung wird durch Bezugnahme in die vorliegende Beschreibung aufgenommen.

Hintergrund der Erfindung

Die Erfindung betrifft eine Vorrichtung sowie ein Verfahren zum Verändern einer Form einer Oberfläche eines Objekts.

Aus DE102012212199A1 ist beispielsweise eine derartige Vorrichtung bekannt. Diese umfasst eine Formmanipulationseinrichtung zur Oberflächenstrukturierung von mikro- oder nanostrukturierten Bauteilen aus Glas oder Keramik mittels Elektronenbestrahlung. Dazu kann ein Teilchenstrahl, wie etwa ein Elektronenstrahl, mit einem Durchmesser im Bereich der kleinsten zu erzeugenden Strukturen auf ausgewählte Teilbereiche der Oberfläche gerichtet werden, um eine lokale Verdichtung und somit eine lokale Absenkung der Oberfläche entsprechend der gewünschten Oberflächenstrukturierung zu erzielen. Weiterhin wird eine Bearbeitung eines optischen Elements einer Projektionsbelichtungsanlage für die Mikrolithographie mit einem Elektronenstrahl beschrieben. Durch den Herstellungsprozess bedingte Abbildungsfehler der Projektionsbelichtungsanlage können durch eine geeignet ausgeführte Verdichtung und eine damit einhergehende Änderung der Form der optischen Oberfläche eines optischen Elements kompensiert werden. Teilchenstrahlen können neben der beschriebenen Materialverdichtung auch zum direkten Materialabtrag an der Oberfläche des bestrahlten optischen Elements und damit allgemein zur Formveränderung der Oberfläche des Objekts eingesetzt werden.

Dabei wird üblicherweise zunächst die tatsächliche Form der Oberfläche des optischen Elements vermessen und deren Abweichung von einer vorgegebenen Sollform bestimmt. Zur Anpassung der Oberflächenform an die Sollform wird herkömmlicherweise zunächst eine Vorgabe für eine Steuerungsgröße der Formmanipulationseinrichtung, etwa in Form einer Energiedosisverteilung eines Elektronenstrahls, bestimmt, die dazu geeignet ist, eine gewünschte Korrektur der Oberflächenform des optischen Elements zu bewirken.

Es hat sich jedoch herausgestellt, dass mit der beschriebenen herkömmlichen Formmanipulationseinrichtung das Erreichen einer geringen Oberflächenabweichung oft sehr zeitaufwändig ist.

Zugrunde liegende Aufgabe

Es ist eine Aufgabe der Erfindung, eine Vorrichtung sowie ein Verfahren der eingangs genannten Art bereitzustellen, womit die vorgenannten Probleme gelöst werden, und womit insbesondere die Oberfläche eines Objekts auf zeiteffiziente Weise an eine Sollform angepasst werden kann.

Erfindungsgemäße Lösung

Die vorgenannte Aufgabe kann erfindungsgemäß beispielsweise gelöst werden mit einer Vorrichtung zum Verändern einer Form einer Oberfläche eines Objekts. Die Vorrichtung umfasst eine Formmanipulationseinrichtung, welche dazu konfiguriert ist, in mindestens zwei Bearbeitungsvorgängen in Abhängigkeit von einer Steuerungsgröße eine Veränderung der Oberfläche des Objekts zu bewirken, wobei mindestens ein Abschnitt der Oberfläche in jedem der Bearbeitungsvorgänge bearbeitet wird. Weiterhin umfasst die Vorrichtung eine Steuerungseinrichtung, welche dazu konfiguriert ist, aus einer vorgegebenen Solländerung der Oberflächenform des Objekts eine Vorgabe für die Steuerungsgröße der Formmanipulationseinrichtung mittels einer Optimierung zu ermitteln, bei der eine Gesamtzeit, welche zur Erzeugung der durch die mindestens zwei Bearbeitungsvorgänge erfolgenden Oberflächenänderung benötigt wird, minimiert wird. Der Abschnitt, der von jedem der mindestens zwei der Bearbeitungsvorgänge bearbeitet wird, umfasst mindestens 10% der gesamten von der Formmanipulationseinrichtung bearbeiteten Oberfläche.

Durch die dahingehende erfindungsgemäße Konfiguration der Formmanipulationseinrichtung, dass damit in mehreren Bearbeitungsvorgängen, wie etwa mit mehreren unterschiedlichen Bearbeitungswerkzeugen und/oder mit unterschiedlich feinen Bearbeitungseinstellungen, eine Veränderung der Oberfläche bewirkt werden kann, lässt sich die notwendige Materialabtragung, Materialkompaktierung bzw. Materialauftragung effizient bewerkstelligen. So ist es beispielsweise möglich, die Oberfläche zunächst mit einem großen bzw. groben aber ungenauen Werkzeug und danach mit einem feinen Werkzeug zu bearbeiten, womit in der Regel ein Endergebnis mit hoher Genauigkeit in einer kürzeren Bearbeitungszeit als bei ausschließlicher Verwendung des feinen Werkzeugs erzielt werden kann.

Bei der erfindungsgemäßen Konfiguration erfolgt eine gesamtheitliche Betrachtung aller Bearbeitungsvorgänge. Damit ist die Verteilung auf die Bearbeitungsvorgänge, vorteilhafterweise auf mehrere Bearbeitungswerkzeuge, optimal bezüglich der Gesamtbearbeitungszeit und der Spezifikation. Die erfindungsgemäße Steuerung der Formmanipulationseinrichtung ermöglicht im Vergleich zu einer sequentiellen Vorgehensweise bei der Ermittlung der Steuergrößenvorgabe eine weitere Verbesserung der Zeiteffizienz bei der Bearbeitung der Oberfläche. Unter der sequentiellen Vorgehensweise wird hierbei verstanden, dass zunächst die Steuergrößenvorgabe für den ersten Bearbeitungsvorgang, also z.B. die Bearbeitung mit dem groben Werkzeug, durch eine Optimierung ermittelt wird und danach anhand eines berechneten Restfehlers, die Steuergrößenvorgabe für den zweiten Bearbeitungsvorgang, also z.B. die Bearbeitung mit dem feinen Werkzeug, durch eine weitere Optimierung bestimmt wird.

Durch die erfindungsgemäße Minimierung der Gesamtzeit, welche zur Erzeugung der durch die Bearbeitungsvorgänge erfolgenden Oberflächenänderung benötigt wird, kann etwa der bei der sequentiellen Vorgehensweise mögliche Fall vermieden werden, in dem die Bearbeitung in einem frühen Bearbeitungsvorgang hohe zeitliche Mehraufwände bei späteren Bearbeitungen verursachen. Auch kann ein sogenanntes Overfitting in frühen Bearbeitungsvorgängen vermieden werden, bei dem grobe Werkzeuge auf feine Strukturen optimiert werden. Eine solche unpassende Konfiguration eines früheren Bearbeitungsvorgangs kann unnötig hohe Bearbeitungszeiten in den späteren Bearbeitungsvorgängen zur Folge haben und für bestimmte Strukturen zu späteren Qualitätseinbußen führen.

Außerdem wird durch die erfindungsgemäße Minimierung der Gesamtzeit der mit der sequenziellen Vorgehensweise verbundene Nachteil, dass die Verteilung der Bearbeitungszeit pro Bearbeitungsvorgang nur indirekt über Zwischenschwellwerte für jeden Bearbeitungsvorgang beeinflusst werden kann, umgangen. Die genannten Zwischenschwellwerte definieren bei der sequentiellen Vorgehensweise die im jeweiligen Bearbeitungsvorgang erreichte Oberflächengenauigkeit.

Weiterhin wird bei der erfindungsgemäßen Minimierung der Gesamtzeit die nachteilige Situation vermieden, dass die Optimalität der Gesamtbearbeitungszeit vom bei der sequentiellen Vorgehensweise notwendigen Setzen der einzelnen Schwellwerte abhängt. Bei der erfindungsgemäßen Lösung wird somit kein Experte benötigt, um sinnvolle Zwischenschwellwerte festzulegen. Auch müssen bei der erfindungsgemäßen Minimierung Restfehler bei Kombi-Bearbeitungen nicht gespeichert und für weitere Berechnungen geladen werden.

Gemäß einer Ausführungsform umfasst die Formmanipulationseinrichtung mehrere Bearbeitungswerkzeuge zur Veränderung der Oberfläche, wobei bei einem ersten der Bearbeitungsvorgänge ein erstes der Bearbeitungswerkzeuge und bei einem zweiten der Bearbeitungsvorgänge ein zweites der Bearbeitungswerkzeuge Verwendung findet.

Gemäß einer weiteren Ausführungsform umfasst die Formmanipulationseinrichtung mindestens ein Bearbeitungswerkzeug, wobei bei zwei Bearbeitungsvorgängen jeweils dasselbe Bearbeitungswerkzeug zum Einsatz kommt.

Gemäß einer weiteren Ausführungsform ist die Steuerungseinrichtung dazu konfiguriert, bei der Optimierung für den jeweiligen Bearbeitungsvorgang ein jeweiliges Bearbeitungswerkzeug auszuwählen. Dabei kann z.B. eine computergesteuerte Poliereinrichtung, eine Ionenstrahlbearbeitungseinrichtung, eine Elektronenstrahlbearbeitungseinrichtung etc. als Bearbeitungswerkzeug ausgewählt werden.

Gemäß einer weiteren Ausführungsform ist die Steuerungseinrichtung dazu konfiguriert, für die in den verschiedenen Bearbeitungsvorgängen zum Einsatz kommenden Bearbeitungswerkzeuge jeweils mindestens einen Werkzeugparameter zu optimieren.

Gemäß einer weiteren Ausführungsform umfasst der optimierte Werkzeugparameter eine Bearbeitungsbreite des Bearbeitungswerkzeugs. Diese kann als Linienbreite des Bearbeitungswerkzeugs bezeichnet werden, d.h. die Breite, in der das Bearbeitungswerkzeug entlang einer Bearbeitungsbahn auf die Oberfläche einwirkt. Gemäß einer Ausführungsvariante ist das Auswählen einer beliebigen Bearbeitungsbahn möglich.

Gemäß einer weiteren Ausführungsform ist die Steuerungseinrichtung dazu konfiguriert, die Vorgabe für die Steuerungsgröße, insbesondere für mehrere Steuerungsgrößen, z.B. Verweilzeit, Pulsweite (Strahl), Druck (Polieren), für mindestens drei Bearbeitungsvorgänge, insbesondere für mindestens fünf oder für mindestens zehn Bearbeitungsvorgänge, zu ermitteln.

Gemäß einer weiteren Ausführungsform erfolgt bei der Optimierung die Ermittlung der Vorgabe für die Steuerungsgröße unter Berücksichtigung einer oder mehrerer die Abweichung der Oberflächenänderung von der Solländerung begrenzenden Nebenbedingung bzw. Nebenbedingungen. Diese Nebenbedingungen können beispielsweise die Maschinendynamik betreffen.

Gemäß einer weiteren Ausführungsform ist für jeden der Bearbeitungsvorgänge eine jeweilige Bearbeitungsbahn, entlang welcher die Bearbeitung der Oberfläche des Objekts zu erfolgen hat, vorgegeben.

Gemäß einer weiteren Ausführungsform ist die Steuerungseinrichtung dazu konfiguriert, eine jeweilige optimierte Bearbeitungsbahn für den jeweiligen Bearbeitungsvorgang bei der Optimierung zu ermitteln.

Gemäß einer weiteren Ausführungsform ist die Steuerungseinrichtung dazu konfiguriert, die jeweilige optimierte Bearbeitungsbahn durch Auswahl aus einer vorgegebenen Gruppe an Bahntypen zu bestimmen.

Gemäß einer weiteren Ausführungsform wird ein bei der Optimierung verwendeter Startwert für die Steuerungsgröße mittels einer Voraboptimierung ermittelt, bei der Gradienten von Aufenthaltsdauern eines Bearbeitungswerkzeugs der jeweiligen Bearbeitungsbahn optimiert werden. Unter dem Startwert der Vorgabe für die Steuerungsgröße kann auch ein Startvektor mit jeweiligen Einzelstartwerten für einzelne Vektorelemente der Steuerungsgröße zu verstehen sein.

Gemäß einer weiteren Ausführungsform ist die Vorrichtung dazu konfiguriert, eine Form einer Oberfläche eines optischen Elements, insbesondere einer Linse oder eines Spiegels, einer Projektionsbelichtungsanlage für die Mikrolithographie, insbesondere einer EUV-Projektionsbelichtungsanlage oder einer DUV-Projektionsbelichtungsanlage, an eine Sollform anzupassen. Das optische Element kann ein Element eines Projektionsobjektivs oder eines Beleuchtungssystems der Projektionsbelichtungsanlage sein.

Weiterhin wird erfindungsgemäß ein Verfahren zum Verändern einer Form einer Oberfläche eines Objekts bereitgestellt. Bei diesem Verfahren wird eine Vorgabe für eine Steuerungsgröße einer Formmanipulationseinrichtung aus einer vorgegebenen Solländerung der Oberflächenform des Objekts mittels einer Optimierung ermittelt wird, wobei die Steuerungsgröße zur Ausführung von mindestens zwei Bearbeitungsvorgängen mittels der Formmanipulationseinrichtung dient, in denen mindestens ein Abschnitt der Oberfläche in jedem der Bearbeitungsvorgänge bearbeitet wird. Bei der Optimierung wird eine Gesamtzeit, welche zur Erzeugung der durch die Bearbeitungsvorgänge erfolgenden Oberflächenänderung benötigt wird, minimiert.

Die bezüglich der vorstehend aufgeführten Ausführungsformen, Ausführungsbeispiele bzw. Ausführungsvarianten, etc. der erfindungsgemäßen Vorrichtung angegebenen Merkmale können entsprechend auf das erfindungsgemäße Verfahren übertragen werden und umgekehrt. Diese und andere Merkmale der erfindungsgemäßen Ausführungsformen werden in der Figurenbeschreibung und den Ansprüchen erläutert. Die einzelnen Merkmale können entweder separat oder in Kombination als Ausführungsformen der Erfindung verwirklicht werden. Weiterhin können sie vorteilhafte Ausführungsformen beschreiben, die selbstständig schutzfähig sind und deren Schutz ggf. erst während oder nach Anhängigkeit der Anmeldung beansprucht wird.

Kurzbeschreibung der Zeichnungen

Die vorstehenden, sowie weitere vorteilhafte Merkmale der Erfindung werden in der nachfolgenden detaillierten Beschreibung beispielhafter erfindungsgemäßer Ausführungsbeispiele bzw. Ausführungsformen oder Ausführungsvarianten unter Bezugnahme auf die beigefügten schematischen Zeichnungen veranschaulicht. Es zeigen:

Fig. 1 ein Ausführungsbeispiel einer Vorrichtung zum Verändern einer Form einer Oberfläche eines Objekts mit einer Formmanipulationseinrichtung sowie einer Steuerungseinrichtung zur Ermittlung einer Vorgabe für eine Steuerungsgröße der Formmanipulationseinrichtung,

Fig. 2 eine Darstellung der Oberfläche des Objekts in Draufsicht mit zusätzlich eingezeichneten Bearbeitungstrajektorien der Formmanipulationseinrichtung, sowie

Fig. 3 eine Darstellung einer Ausführungsform eines in der Steuerungseinrichtung ablaufenden Algorithmus zur Ermittlung der Vorgabe für die Steuergröße der Formmanipulationseinrichtung.

Detaillierte Beschreibung erfindungsgemäßer Ausführungsbeispiele

In den nachstehend beschriebenen Ausführungsbeispielen bzw. Ausführungsformen oder Ausführungsvarianten sind funktionell oder strukturell einander ähnliche Elemente soweit wie möglich mit den gleichen oder ähnlichen Bezugszeichen versehen. Daher sollte zum Verständnis der Merkmale der einzelnen Elemente eines bestimmten Ausführungsbeispiels auf die Beschreibung anderer Ausführungsbeispiele oder die allgemeine Beschreibung der Erfindung Bezug genommen werden.

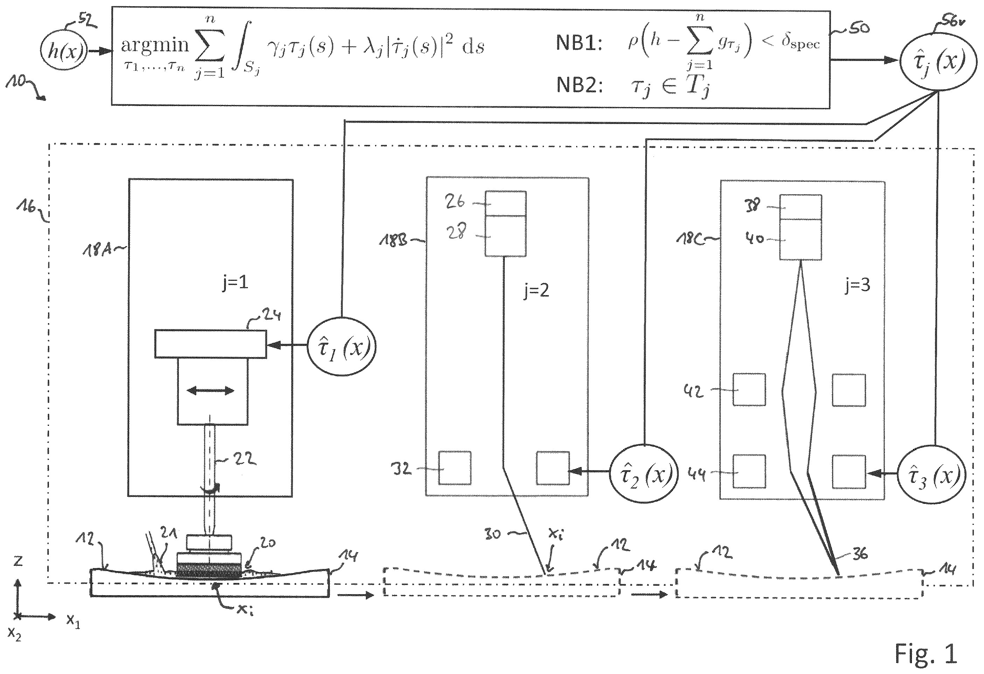

Zur Erleichterung der Beschreibung ist in Fig. 1 ein Koordinatensystem angegeben, aus dem sich die jeweilige Lagebeziehung der in den Figuren dargestellten Komponenten ergibt. Dabei verläuft die $x_1$-Richtung nach rechts, die $x_2$-Richtung in die Zeichenebene hinein und die z-Richtung nach oben. In den in Fig. 1 sowie nachstehend angegebenen Formeln wird mit x ein zweidimensionaler Ortsvektor mit den Koordinaten $(x_1, x_2)$ bezeichnet.

In Fig. 1 wird ein Ausführungsbeispiel einer Vorrichtung 10 zum Verändern einer Form einer Oberfläche 12 eines Objekts 14 in Gestalt eines optischen Elements schematisch dargestellt. Als optisches Element ist exemplarisch ein Spiegel für den EUV-Wellenlängenbereich, d.h. für elektromagnetische Strahlung mit einer Wellenlänge kleiner als 100 nm, insbesondere einer Wellenlänge von etwa 13,5 nm oder etwa 6,8 nm dargestellt.

Dabei kann dieses ein optisches Element für ein Beleuchtungssystem oder eine Projektionsoptik einer Projektionsbelichtungsanlage für die EUV-Mikrolithographie oder die DUV-Mikrolithographie sein. Bei dem mittels der Vorrichtung 10 veränderbaren optischen Element kann es sich dabei beispielsweise um einen Umlenkspiegel, Facetten eines ersten oder eines zweiten Facettenspiegels einer Beleuchtungsoptik um einen Spiegel eines Projektionsobjektivs der Projektionsbelichtungsanlage handeln.

Die Vorrichtung 10 eignet sich aber auch zur hochgenauen Oberflächenformherstellung oder Oberflächenformänderung bei anderen optischen Elementen, wie beispielsweise Spiegeln für andere Wellenlängenbereiche, Linsen oder optischen Elementen mit diffraktiven Strukturen, oder auch bei Objekten, die kein optisches Element bilden.

Die Vorrichtung 10 enthält eine Formmanipulationseinrichtung 16, welche dazu konfiguriert ist, in mehreren Bearbeitungsvorgängen in Abhängigkeit von einer Steuerungsgröße eine Veränderung der Oberfläche 12 des Objekts 14 zu bewirken. Die Formmanipulatonseinrichtung 16 umfasst mehrere Bearbeitungswerkzeuge 18A, 18B und 18C. Dabei handelt es sich beim Bearbeitungswerkzeug 18A um eine computergesteuerte Poliereinrichtung, beim Bearbeitungswerkzeug 18B um eine Ionenstrahlbearbeitungseinrichtung und beim Bearbeitungswerkzeug 18C um eine Elektronenstrahlbearbeitungseinrichtung.

Die Formmanipulationseinrichtung 16 kann in anderen Ausführungsformen weitere Bearbeitungswerkzeuge 18, insbesondere etwa auch ein Bearbeitungswerkzeug zum Auftragen von Material auf die Oberfläche 12, ein Bearbeitungswerkzeug zum Bestrahlen der Oberfläche 12 mit ungeladenen Teilchen, ein Laserstrahlbearbeitungswerkzeug oder ein auf Plasma-assistierten chemischen Ätzprozessen beruhendes Bearbeitungswerkzeug, oder auch weniger Bearbeitungswerkzeuge 18 umfassen. So kann die Formmanipulationseinrichtung 16 auch lediglich ein Bearbeitungswerkzeug 18 umfassen, welches zur Ausführung von mehreren Bearbeitungsvorgängen mit unterschiedlichen Betriebsparametern, wie etwa unterschiedlichen Spurbreiten, betrieben werden kann. Die Formmanipulationseinrichtung kann auch unterschiedliche Bearbeitungswerkzeuge einer Bearbeitungstechnologie, insbesondere unterschiedliche Werkzeugtypen, wie etwa Wheel- und Exzenter-Polierwerkzeuge, umfassen.

Die computergesteuerte Poliereinrichtung 18A (engl. computer controlled polisher) umfasst eine kleine rotierende Polierscheibe 20, welche mit einer Motorspindel 22 angetrieben wird. Während des Polierprozesses wir ein Poliermittel 21 auf die zu bearbeitende Oberfläche 12 aufgetragen. Die Motorspindel 22 wird von einer Verschiebeeinheit 24 gehalten, womit die Polierscheibe 20 während ihrer Poliertätigkeit in $x_1$ - und $x_2$ -Richtung und damit entlang der Oberfläche 12 des Objekts 14 verschoben werden kann. Durch genaue Steuerung der Rotations- und Verschiebegeschwindigkeit der Polierscheibe 20 wird eine vorgegebene Materialmenge an jedem bearbeiteten Punkt der Oberfläche 12 abgetragen. Eine sogenannte Spurbreite der Poliereinrichtung 18A kann durch die Verwendung von Polierscheiben 20 mit unterschiedlichen Durchmessern variiert werden. Gemäß einer Ausführungsvariante kann die Poliereinrichtung als Exzenter-Werkzeug konfiguriert werden, bei dem die Motorspindel 22 bzw. die Antriebwelle mit einer Steuerungsschreibe angetrieben wird, deren Mittelpunkt außerhalb der Wellenachse liegt.

Die Ionenstrahlbearbeitungseinrichtung 18B umfasst zur Erzeugung eines Ionenstrahls 30 eine Ionenquelle 26 sowie eine Beschleunigungseinheit 28. Mit einer Ablenkungseinheit 32 lässt sich der Ionenstrahl 30 sowohl in $x_1$- als auch in $x_2$-Richtung ablenken. Hierfür enthält die Ablenkungseinheit 32 geeignet ausgebildete elektrische oder magnetische Komponenten. Die Ionen werden typischerweise vor dem Auftreffen auf die Oberfläche 12 neutralisiert. Je nach Einstellung der Ablenkungseinheit 32 trifft der Ionenstrahl 30 an einem bestimmten Ort $x_i = (x_1^i, x_2^i)$ auf die Oberfläche 12 des optischen Elements 14 auf. Auf diese Weise lässt sich nacheinander eine Vielzahl von verschiedenen Orten $x_i$ auf der Oberfläche 12 bestrahlen und somit eine ortsaufgelöste Wirkungsverteilung in Form einer Energiedosisverteilung über die Oberfläche 12 erzielen. Alternativ lassen sich $x_1$ und $x_2$ Position und Strahlwinkel durch mechanische Bewegung der Quelle einstellen.

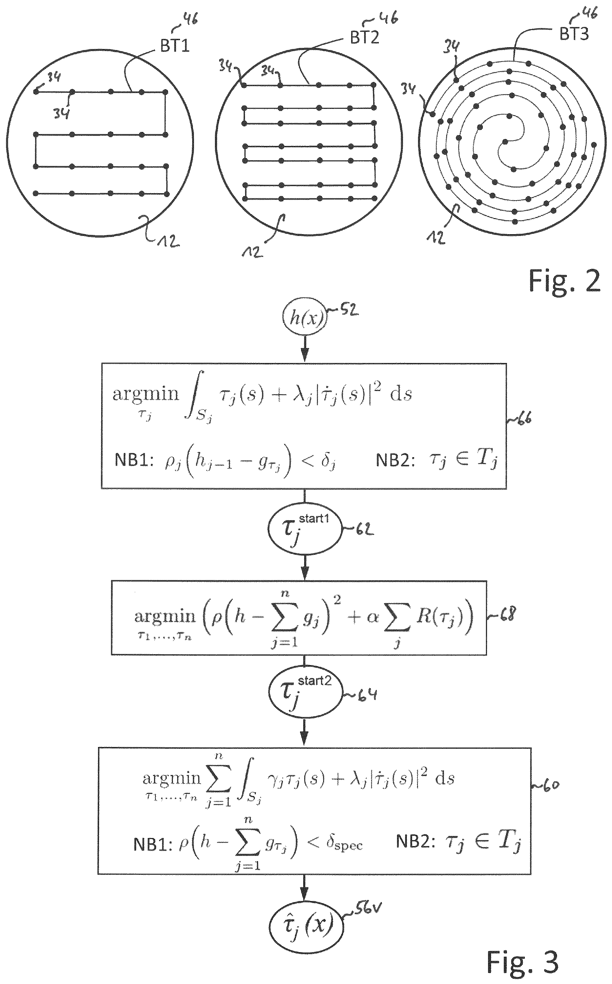

Unter der ortsaufgelösten Energiedosisverteilung ist hier eine Verteilung der eingebrachten Energie pro Fläche als Funktion der Ortskoordinate $x = (x_1, x_2)$ der Oberfläche 12 des optischen Elements 14 zu verstehen. Dabei kann die Bestrahlung entlang vorgegebener Bahntypen 46 erfolgen. In Fig. 2 sind beispielhaft verschiedene Bearbeitungstrajektorien in Gestalt von rasterartigen Bahntypen BT1 und BT2 mit unterschiedlichen bzw. variierenden Rasterlinenabständen sowie in Gestalt eines spiralförmigen Bahntyps BT3 veranschaulicht. Die Bestrahlung kann auch kontinuierlich über die Oberfläche oder in anderen Bahntypen, wie etwa Kreisen, Ellipsen oder dergleichen erfolgen.

Auf den Bahnlinien bzw. Bearbeitungstrajektorien der veranschaulichten Bahntypen BT1, BT2 und BT3 sind Punkte eingezeichnet, welche Verweilorte 34 des Ionenstrahls 30 bei der Bearbeitung der Oberfläche 12 darstellen. Dabei sind zur besseren Übersichtlichkeit der Darstellungen lediglich einige der Verweilorte 34 mit einem Bezugzeichen versehen. Dieser und der vorausgehende Abschnitt betreffen nicht nur Ionenbestrahlung, sondern auch andere Bearbeitungsverfahren.

Die Elektronenstrahlbearbeitungseinrichtung 18C umfasst zur Erzeugung eines Elektronenstrahls 36 eine Elektronenquelle 38 und eine Beschleunigungseinheit 40. Als Elektronenquelle 38 kann beispielsweise eine Glühkathode, eine Kristallkathode oder eine Feldemissions-Kathode verwendet werden. Die Beschleunigungseinheit 40 beschleunigt und bündelt die von der Elektronenquelle 38 emittierten Elektronen. Dazu kann die Beschleunigungseinheit 40 eine Anode mit einem gegenüber der Elektronenquelle 38 hohen positiven elektrostatischen Potential und einer kleinen Austrittsöffnung für die beschleunigten Elektronen aufweisen. Zum Bündeln und zum Einstellen der Intensität des Elektronenstrahls 36 enthält die Beschleunigungseinheit 40 ferner eine Steuerelektrode, beispielsweise einen Wehneltzylinder. Die Intensität bzw. der Strahlstrom gibt die Anzahl der Elektronen an, welche pro Zeiteinheit durch eine senkrecht zum Elektronenstrahl gedachte Fläche treten.

Zum Fokussieren des von der Beschleunigungseinheit 40 kommenden Elektronenstrahls 36 umfasst die Elektronenstrahbestrahlungseinrichtung 18C weiterhin eine Fokussierungseinheit 42 mit geeignet ausgebildeten elektrischen oder magnetischen Komponenten.

Mit einer Ablenkungseinheit 44 der Teilchenbestrahlungseinrichtung 16 lässt sich der Elektronenstrahl 36 sowohl in $x_1$- als auch in $x_2$-Richtung ablenken. Hierfür enthält die Ablenkungseinheit 44 ebenfalls geeignet ausgebildete elektrische oder magnetische Komponenten. Je nach Einstellung der Ablenkungseinheit 44 trifft der Elektronenstrahl 36 analog zum Ionenstrahl der Ionenstrahlbearbeitungseinrichtung 18B an einem bestimmten Ort $x_i = (x_1^i, x_2^i)$ auf die Oberfläche 12 des optischen Elements 14 auf.

Auf diese Weise lässt sich nacheinander eine Vielzahl von verschiedenen Orten auf der Oberfläche 12 bestrahlen und somit eine ortsaufgelöste Wirkungsverteilung in Form einer Energiedosisverteilung über die Oberfläche 12 erzielen. Analog zur Ionenstrahlbearbeitungseinrichtung 18B kann die Bestrahlung entlang vorgegebener Bahntypen, insbesondere entlang der in Fig. 2 veranschaulichten Bahntypen, erfolgen.

Zur Vermeidung einer Absorption der Elektronen des Elektronenstrahls 36 durch Luft weist die Elektronenstrahlbearbeitungseinrichtung 18C ferner eine Vakuumkammer auf, in welcher die Elektronenquelle 38, die Beschleunigungseinheit 40, die Fokussierungseinheit 42, die Ablenkeinheit 44 und das Objekt 14 bzw. zumindest die Oberfläche 12 des Objekts 14 angeordnet sind. Eine derartige Vakuumkammer kommt vorzugsweise auch bei der Ionenstrahlbearbeitungseinrichtung 18B zum Einsatz.

Der von der Ionenstrahlbearbeitungseinrichtung 18B bzw. der Elektronenstrahlbearbeitungseinrichtung 18C erzeugte Teilchenstrahl, d.h. der Ionenstrahl 30 bzw. der Elektronenstrahl 36, ist insbesondere energetisch derart ausgebildet, dass je nach Energiedosis ein mehr oder weniger stark ausgeprägter lokaler Abtrag bzw. eine mehr oder weniger stark ausgeprägte lokale Kompaktierung des Materials des Objekts 14 an der Oberfläche 12 bewirkt wird. Als Energiedosis ist die Energie pro Fläche zu verstehen, welche durch den Teilchenstrahl in das Objekt 14 eingebracht wird. Die Energiedosis ist somit insbesondere von der Verweildauer, in diesem Text auch Aufenthaltsdauer bezeichnet, des Elektronenstrahls am ausgewählten Ort, von dessen Intensität und insbesondere von der Energie pro Teilchen abhängig.

Sowohl ein Materialabtrag als auch eine lokale Kompaktierung bewirkt eine lokale Absenkung der Oberfläche 12 am Objekt 14, wie etwa einem optischen Element. Eine Kompaktierung tritt insbesondere in amorphen Materialien durch eine Umverteilung von Elektronenbindungen auf. Dabei erfolgt die lokale Kompaktierung in allen Raumrichtungen, d.h. es findet nicht nur eine lokale Oberflächenabsenkung im Bereich eines Flächenelements in negativer z-Richtung sondern auch eine Kompaktierung parallel zur Oberfläche 12 statt. Dabei entstehen parallel zur Oberfläche 12 wirkende Kräfte, wodurch Spannungen in das Objekt 14 induziert werden. Diese Spannungen können eine Verformung eines gegenüber dem von der lokalen Kompaktierung betroffenen Flächenelement wesentlich größeren Oberflächenabschnitts bewirken. Der Oberflächenabschnitt kann einen Teil der Oberfläche 12 oder auch die gesamte Oberfläche 12 umfassen.

Die Vorrichtung 10 enthält weiterhin eine Steuerungseinrichtung 50 zum Steuern eines oder mehrerer der Bearbeitungswerkzeuge 18 beim Ausführen der Bearbeitungsvorgänge. Die Steuerungseinrichtung 50 ist dazu konfiguriert, aus einer mit dem Bezugszeichen 52 bezeichneten vorgegebenen Solländerung $h(x)$ für die Form der Oberfläche 12 des optischen Elements 14 eine mit dem Bezugszeichen 56v bezeichnete Vorgabe $\hat{\tau}_j(x)$ für eine mit dem Bezugszeichen 56 bezeichnete Steuerungsgröße $\tau_j(x)$ der Formmanipulationseinrichtung 16 zu ermitteln.

Dabei handelt es sich im vorliegenden Fall bei der Steuerungsgröße $\tau_j(x)$ um eine Aufenthaltsdauer des betreffenden Bearbeitungswerkzeugs 18 in Abhängigkeit von der Position $x \in \mathbb{R}^2$ auf der zu bearbeitenden Oberfläche 12. Dabei indiziert j den jeweiligen Bearbeitungsvorgang, wobei im Ausführungsbeispiel gemäß Fig. 1 jeweils ein Bearbeitungsvorgang von jedem der Bearbeitungswerkzeuge 18A bis 18C ausgeführt wird. Damit indiziert j die Bearbeitung der Oberfläche 12 mit dem jeweiligen Bearbeitungswerkzeug 18A bis 18C. Alternativ können beispielsweise auch Druck oder Pulsweite, etc. als Steuerungsgröße Verwendung finden.

Wie vorstehend bereits erwähnt, können jedoch auch ein oder mehrere Bearbeitungsvorgänge mit dem gleichen Bearbeitungswerkzeug aufgeführt werden, in diesem Fall kann j beispielsweise mehrere mit unterschiedlichen Bearbeitungseinstellungen ausgeführte Bearbeitungsvorgänge eines Bearbeitungswerkzeugs 18 indizieren. Verschiedene Bearbeitungsvorgänge können auch eine mehrfache Bearbeitung zumindest eines Abschnitts der Oberfläche 12 mit demselben Bearbeitungswerkzeug und den gleichen Bearbeitungseinstellungen, also beispielsweise das mehrfache Abfahren einer Bearbeitungsbahn mit der Poliereinrichtung 18A, umfassen.

Mit anderen Worten umfasst die Vorgabe $\hat{\tau}_j(x)$ im Ausführungsbeispiel gemäß Fig. 1 eine Vorgabe $\hat{\tau}_1(x)$ für die Aufenthaltsdauer der Polierscheibe 20 der Poliereinrichtung 18A in Abhängigkeit von der Position $x \in \mathbb{R}^2$ auf der zu bearbeitenden Oberfläche 12. Beispielsweise kann dabei für die Poliereinrichtung 18A der erste in Fig. 2 dargestellte Bahntyp BT1 vorgesehen sein. Die Vorgabe $\hat{\tau}_j(x)$ definiert dann jeweilige Aufenthaltsdauern an den einzelnen Verweilorten 34 der Bahnlinie des Bahntyps BT1.

Weiterhin umfasst die Vorgabe $\hat{\tau}_j(x)$ im Ausführungsbeispiel gemäß Fig. 1 eine Vorgabe $\hat{\tau}_2(x)$ für die Aufenthaltsdauer des Ionenstrahls 30 der Ionenstrahlbearbeitungseinrichtung 18B in Abhängigkeit von der Position $x \in \mathbb{R}^2$ auf der zu bearbeitenden Oberfläche 12. Beispielsweise kann dabei für die Ionenstrahlbearbeitungseinrichtung 18B der zweite in Fig. 2 dargestellte Bahntyp BT2 vorgesehen sein. Die Vorgabe $\hat{\tau}_2(x)$ definiert dann jeweilige Aufenthaltsdauern an den einzelnen Verweilorten 34 der Bahnlinie des Bahntyps BT2.

Weiterhin umfasst die Vorgabe $\hat{\tau}_j(x)$ im Ausführungsbeispiel gemäß Fig. 1 eine Vorgabe $\hat{\tau}_3(x)$ für die Aufenthaltsdauer des Elektronenstrahls 36 der Elektronenstrahlbearbeitungseinrichtung 18C in Abhängigkeit von der Position $x \in \mathbb{R}^2$ auf der zu bearbeitenden Oberfläche 12. Beispielsweise kann dabei für die Elektronenstrahlbearbeitungseinrichtung 18C der dritte in Fig. 2 dargestellte Bahntyp BT3 vorgesehen sein. Die Vorgabe $\hat{\tau}_3(x)$ definiert dann jeweilige Aufenthaltsdauern an den einzelnen Verweilorten 34 der Bahnlinie des Bahntyps BT3.

Wie bereits vorstehend erwähnt, wird vorliegend die Solländerung 52 der Oberflächenform mit h(x) bezeichnet. Die Steuerungsgröße 56 wird durch eine Aufenthaltsdauer $\tau(x)$ des betreffenden Bearbeitungswerkzeugs 18 in Abhängigkeit von der Position $x \in \mathbb{R}^2$ auf der zu bearbeitenden Oberfläche 12 beschrieben. Die Wirkung des Werkzeugs auf die Oberfläche 12 wird durch eine sogenannte Werkzeugfunktion k(y), $y \in \mathbb{R}^2$ charakterisiert.

Eine mit dem Bezugszeichen 58 bezeichnete Oberflächenänderungsvorhersage g(x), im Fall des Materialabtrags auch Abtragsvorhersage bezeichnet, ergibt sich dann wie folgt:

$$g(x) = \int_{\Omega'} \tau(y)k(x-y)dy \tag{1}$$

Mit anderen Worten wird g(x) durch die Faltung $g = \tau \otimes k$ auf einem zweidimensionalen Gebiet $\Omega' \subset \mathbb{R}^2$ beschrieben. Das Gebiet $\Omega'$ beschreibt hierbei eine Bearbeitungsfläche auf der Oberfläche 12 des Objekts 14.

Die Steuerungseinrichtung 50 ist dazu konfiguriert, zur Ermittlung der Vorgabe $\hat{\tau}_j(x)$ aus der vorgegebenen Solländerung h(x) eine Optimierung durchzuführen. Dies erfolgt durch Minimierung einer Zielfunktion:

$$\underset{\tau_1,\dots,\tau_n}{\operatorname{argmin}} \sum_{j=1}^{n} \int_{S_j} \gamma_j \tau_j(s) + \lambda_j |\dot{\tau}_j(s)|^2 \, \mathrm{d}s \tag{2}$$

Hierbei sind n die Anzahl der Bearbeitungsvorgänge (im Ausführungsbeispiel gemäß Fig. 1 gilt n=3), $\gamma_j$ sind Nutzerparameter, um die Bearbeitungszeiten der verschiedenen Bearbeitungsvorgänge bzw. der verschiedenen Bearbeitungswerkzeuge 18 zu gewichten (z.B. wegen unterschiedlicher Kosten oder Verfügbarkeit) und $\lambda_j$ sind Nutzerparameter zur Steuerung einer Glattheit der Lösung. Unter der Glattheit der Lösung sind Gradienten der Aufenthaltsdauer $\tau(x)$ bzw. Verweilzeit beim Übergang von Verweilort 34 zu Verweilort 34 zu verstehen.

Die Minimierung gemäß (2) erfolgt unter einer ersten Nebenbedingung:
NB1:

$$\rho\left(h - \sum_{j=1}^{n} g_{\tau_j}\right) < \delta_{\text{spec}} \tag{3}$$

sowie einer zweiten Nebenbedingung:
NB2:

$$\tau_j \in T_j \tag{4}$$

Hierbei stellt in der Nebenbedingung NB1 $\rho$ eine Funktion zur Quantifizierung der Oberflächenabweichung bzw. Rauheit nach der Bearbeitung dar. So kann $\rho$ eine Distanzfunktion im Allgemeinen und eine Funktion zur Berechnung der Standardabweichung über die Oberfläche 12 im Speziellen sein. Weiterhin stellt $\delta_{\text{spec}}$ die durch die Bearbeitung der Oberfläche im Rahmen aller vorgesehenen Bearbeitungsvorgänge zu erzielende finale Spezifikation für $\rho$ dar.

In der Nebenbedingung NB2 ist $T_j$ eine Menge von zulässigen Aufenthaltsdauern für den Bearbeitungsvorgang j. Eine mögliche Einschränkung ist, dass die Bahnlinie bzw. Trajektorie des jeweiligen Bearbeitungsvorgangs für die Ausführung in Intervalle unterteilt wird, auf denen sich das Bearbeitungswerkzeug 18 mit konstanter Geschwindigkeit bewegt. Auf jedem dieser Intervalle hat das Bearbeitungswerkzeug eine Mindestverweilzeit, die sich aus maximaler Geschwindigkeit des Bearbeitungswerkzeugs 18 und einer Satzwechselzeit $t_j^{\mathrm{sw}}$ ergibt. Unter der Satzwechselzeit $t_j^{\mathrm{sw}}$, ist die Zeit zu verstehen, die benötigt wird, um einen geänderten Steuerungsdatensatz in die Steuerung des Bearbeitungswerkzeugs 18 nachzuladen. Mit anderen Worten ist die Satzwechselzeit die Zeit, welche die Steuerung benötigt, um die Vorgabe für den nächsten Punkt zu verarbeiten. $C_j = \{c_j(s_i)|\, s_j^1, \ldots, s_j^N \in S_j\}$ sei die Menge der Punkte (auch Stützstellen genannt), an denen die Geschwindigkeit des Bearbeitungswerkzeugs 18 geändert wird. Dann können unter Berücksichtigung der maximalen Geschwindigkeit $v_j^{\mathrm{max}}$ und der Satzwechselzeit $t_j^{\mathrm{sw}}$ die Menge der zulässigen Aufenthaltsdauern wie folgt beschrieben werden:

$$T_j = \left\{ \tau: S \to \mathbb{R}_{\geq 0}\middle|\ \tau(s) = \tau(s_i)\ \forall s \in \left[s_j^i, s_j^{i+1}\right)\ \forall i \right. \tag{5}$$

$$\left. t_i \geq \max\left(\frac{s_{i+1} - s_i}{v_j^{\mathrm{max}}}, t_j^{\mathrm{sw}}\right) \right\} \tag{6}$$

Bei der Optimierung gemäß (2) wird die Gesamtbearbeitungszeit, welche zur Erzeugung der durch die unterschiedlichen Bearbeitungsvorgänge erfolgende Änderung der Oberfläche 12 benötigt wird, minimiert. Die dazu minimierte Zielfunktion umfasst dazu die Summe eines Integrals über die zweidimensionale Ortskoordinate $x = (x_1, x_2)$ auf der Oberfläche 12 des Objekts 14.

Als Optimierungsverfahren zur Minimierung der Zielfunktion kann gemäß einer beispielhaften Ausführungsform ein als Innere-Punkte Verfahren ausgelegtes Standardverfahren für konvexe Optimierung verwendet werden, d.h. es wird eine zulässige Initiallösung, welche die Nebenbedingungen NB1 und NB2 erfüllt, benötigt. Dieses kann z.B. durch eine Lösung des Problems mit einer realisierbaren Nutzervorgabe sichergestellt werden. Danach kann die Nebenbedingung NB1 in einer Ausführungsform mittels einer logarithmischen Barriere realisiert werden. Die Optimierung gemäß (2) kann auch mit einem anderen geeigneten Optimierungsverfahren gelöst werden. Darunter können klassische Optimierungsalgorithmen und auch anders geartete Algorithmen, wie etwa maschinelle Lernverfahren, fallen.

Im vorliegenden Fall wird die Gesamtzeit zur Bearbeitung der Oberfläche mit den Bearbeitungswerkzeugen 18A, 18B und 18C minimiert. Gleichzeitig wird durch den in der Zielfunktion enthaltene Bestrafungsterm $\lambda_j|\tau_j(s)|^2$ dabei der Ortsgradient der Lösung, d.h. der Vorgabe $\hat{\tau}_j(x)$ für die Steuerungsgröße 56, gering gehalten, d.h. die Lösung wird glatt gehalten. Die Nebenbedingung NB1 stellt die finale Spezifikation $\delta_{\mathrm{spec}}$ für die Oberflächenabweichung sicher.

Wie in Fig. 3 veranschaulicht, wird gemäß einem Ausführungsbeispiel das mit dem Bezugszeichen 60 bezeichnete Optimierungsproblem gemäß (2) unter Nutzung eines mit dem Bezugszeichen 64 bezeichneten Startwerts $\tau_j^{\mathrm{start2}}$ für die Steuerungsgröße $\tau_j(x)$ gelöst. Der Startwert $\tau_j^{\mathrm{start2}}$ stellt einen Startvektor mit Einzelstartwerten für die Bahnpunkte bei der Bearbeitung der Oberfläche 12 mit den Bearbeitungswerkzeugen 18 dar.

Zur Bestimmung des Startwerts $\tau_j^{\mathrm{start2}}$ wird zunächst ein mit dem Bezugszeichen 62 bezeichneter Vorabstartwert $\tau_j^{\mathrm{start1}}$ durch Lösung des folgenden, mit dem Bezugszeichen 66 bezeichneten, Voraboptimierungsproblems bestimmt:

$$\underset{\tau_j}{\operatorname{argmin}} \int_{S_j} \tau_j(s) + \lambda_j|\dot{\tau}_j(s)|^2\ \mathrm{d}s$$

NB1:

$$\rho_j \left( h_{j-1} - g_{\tau_j} \right) < \delta_j \qquad \text{NB2:} \quad \tau_j \in T_j \tag{7}$$

Das Voraboptimierungsproblem 66 unterscheidet sich von dem vorstehend erläuterten Optimierungsproblem dahingehend, dass hierbei die Optimierung der Bearbeitungszeit für die einzelnen Bearbeitungsvorgänge j nacheinander, also sequentiell erfolgt. Dabei wird für jeden Bearbeitungsvorgang j eine eigene Spezifikation $\delta_j$ angesetzt. Die Funktion $\rho_j$ der Nebenbedingung NB1 kann gemäß einer Ausführungsform für alle Bearbeitungsvorgänge j gleich gewählt werden. Durch Lösen des Voraboptimierungsproblems 66 wird aus der vorgegebenen Solländerung h(x) der Vorabstartwert

$$\tau_j^{\text{start1}}$$

bestimmt. Dieser wird als Startwert zur Lösung des folgenden weiteren Voraboptimierungsproblems 68 genutzt:

$$\underset{\tau_1,\ldots,\tau_n}{\operatorname{argmin}} \left( \rho \Big( h - \sum_{j=1}^{n} g_j \Big)^2 + \alpha \sum_j R(\tau_j) \right) \tag{8}$$

Hierbei definiert R eine Regularisierung der Bearbeitungsfelder, dies kann die Glattheit der Lösung oder die Bearbeitungszeit sein, $\alpha$ ist der Regularisierungsparameter, der verringert wird, bis die Lösung des initialen Problems die Bedingung

$$\rho \Big( h - \sum_{j=1}^{n} g_j \Big) < \beta \delta_{\text{spec}}, \ \beta \in [0, 1] \tag{9}$$

erfüllt. Die Lösung des weiteren Voraboptimierungsproblems 68 ist der Startwert $\tau_j^{\text{start2}}$ für das vorstehend beschriebene Haupt-Optimierungsproblem 60.

Für den Fall, in dem R die Glattheit der Lösung regularisiert, dient das Optimierungsproblem 68 dazu, Gradienten von Aufenthaltsdauern der Bearbeitungswerkzeuge 18A, 18B und 18C der jeweiligen Bearbeitungsbahn oder andere dynamischen Größen (z.B. Geschwindigkeiten, Beschleunigungen der Bearbeitungswerkzeuge etc.) zu optimieren.

Das Verfahren kann weiterhin auch genutzt werden, um eine gewünschte Oberflächenrauheit, den Ziel-RMS, in einem Teilgebiet $\Omega' \subset \Omega$ des gesamten zu bearbeitenden Gebiets $\Omega$ der Oberfläche 12 zu erreichen. In diesem Fall ist

$$\rho(h) = \frac{1}{|\Omega'|} \sqrt{\int_{\Omega'} |h(x) - \bar{h}|^2 \mathrm{d}x} \tag{10}$$

mit

$$\bar{h} = \frac{1}{|\Omega'|} \int_{\Omega'} h(x) \mathrm{d}x. \tag{11}$$

Durch die Nebenbedingung NB2 ($\tau_j \in T_j$) des Optimierungsproblems 60 können gemäß einer Ausführungsvariante bestimmte Bahntypen 46 bzw. Bahnlinien für die einzelnen Bearbeitungsvorgänge j, wie etwa die Bahntypen BT1, BT2 und BT3 für die Bearbeitung mit den Bearbeitungswerkzeugen 18A, 18B und 18C, fest vorgegebenen sein.

Der Optimierungsalgorithmus ermittelt dann die Vorgabe $\hat{\tau}_j(x)$ mit betreffenden Aufenthaltsdauern der eingesetzten Bearbeitungswerkzeuge 18 entlang der betreffenden Bahntypen 46. Gemäß einer alternativen Ausführungsvariante kann der Optimierungsalgorithmus auch dazu konfiguriert sein, aus einer vorgegebenen Menge an Bahntypen für jeden Bearbeitungsvorgang einen geeigneten Bahntyp 46 auszuwählen und die Vorgabe $\hat{\tau}_j(x)$ mit den Aufenthaltsdauern entlang der ausgewählten Bahntypen zu ermitteln.

Gemäß einer weiteren Ausführungsvariante kann der Optimierungsalgorithmus auch dazu konfiguriert sein, für die verschiedenen Bearbeitungsvorgänge j vorgegebene Bahntypen 46 in ihrem genauen Verlauf zu optimieren, also deren Verlauf anzupassen, und die Vorgabe $\hat{\tau}_j(x)$ mit den Aufenthaltsdauern entlang der angepassten bzw. optimierten Bahntypen zu bestimmen. Weiterhin kann der Optimierungsalgorithmus auch dazu konfiguriert sein, zunächst aus einer vorgegebenen Menge an Bahntypen für jeden Bearbeitungsvorgang einen geeigneten Bahntyp 46 auszuwählen und weiterhin die ausgewählten Bahntypen in ihrem genauen Verlauf zu optimieren.

Gemäß einer weiteren Ausführungsform ist der Optimierungsalgorithmus dazu konfiguriert, ohne jegliche Vorgabe von Bahntypen, für die verschiedenen Bearbeitungsvorgänge j die optimierten Bahnverläufe zu ermitteln. Mit anderen Worten werden die Positionen der Bahnpunkte optimiert. Insbesondere kann mindestens einer der Bahnverläufe durch einen Zufallsverlauf, einen sogenannten "Random Walk" bzw. einen derartigen Verlauf, bei dem die Abtragsvorgabe berücksichtigt wird (sogenannter "biased Random Walk"), gekennzeichnet sein.

Die in den verschiedenen Bearbeitungsvorgängen j verwendeten Bearbeitungswerkzeuge 18 können bereits vor der Lösung des Optimierungsproblems 60 vorgegeben sein. Gemäß einer alternativen Ausführungsvariante kann der Optimierungsalgorithmus dazu konfiguriert sein, die in den einzelnen Bearbeitungsvorgängen verwendeten Bearbeitungswerkzeuge 18 aus einer vorgegebenen Menge an Bearbeitungswerkzeugen auszuwählen. Insbesondere kann der Optimierungsalgorithmus auch dazu konfiguriert sein, Werkzeugparameter der verwendeten Bearbeitungswerkzeuge, wie etwa die Linienbreite bzw. Werkzeuggröße des betreffenden Bearbeitungswerkzeugs, für die jeweiligen Bearbeitungsvorgänge j zu definieren bzw. zu optimieren. Gemäß einer Ausführungsvariante trifft der Optimierungsalgorithmus für jeden Bearbeitungsvorgang eine Auswahl des zu nutzenden Bearbeitungswerkzeugs sowie eine Auswahl der beim Betrieb der Bearbeitungswerkzeuge genutzten Werkzeugparameter.

$$\rho\left(h - \sum_{j=1}^{n} g_{\tau_j}\right) < \delta_{\text{spec}}$$

Die in der Nebenbedingung NB1 ( ) des Optimierungsproblems 60 enthaltene Funktion $\rho$ zur Quantifizierung der Oberflächenabweichung bzw. Rauheit der Oberfläche 12 kann gemäß einer Ausführungsvariante frequenzbandabhängig definiert sein. Das heißt, unterschiedlichen Frequenzbändern der Oberflächenabweichung werden beispielsweise unterschiedliche RMS-Spezifikationen zugeordnet. Weiterhin können für unterschiedliche Oberflächenbereiche des Objekts 14 unterschiedliche Spezifikationen vorgegeben sein. Dabei können diese Oberflächenbereiche Bereiche eines in einer Lithographie-Projektionsbelichtungsanlage integrierten optischen Elements sein, welche im Belichtungsbetrieb der Projektionsbelichtungsanlage in unterschiedlichen Drehstellungen des optischen Elements von der Belichtungsstrahlung angestrahlt werden. Mit anderen Worten können die Optimierungsbereiche auf der Oberfläche 12 des Objekts 14 gewichtet werden. Allgemein gesagt, können für das Optimierungsproblem 60 komplexe Spezifikationen vorgegeben werden. Insbesondere werden verschiedene Spezifikationen bei der Optimierung gleichzeitig überprüft.

Die bei der Optimierung gemäß (2) ermittelte Vorgabe $\hat{\tau}_j(x)$ definiert die Steuerungsgröße, wie etwa die Aufenthaltsdauer, in Abhängigkeit von der zweidimensionalen Ortskoordinate $x = (x_1, x_2)$ auf der Oberfläche 12 des Objekts 14. Die Optimierung erfolgt damit zweidimensional. Alternativ kann die Optimierung auch dreidimensional erfolgen. Die dabei ermittelte Vorgabe der Steuerungsgröße kann dabei insbesondere in Abhängigkeit einer dreidimensionalen Ortskoordinate $x = (x_1, x_2, z)$ vorliegen.

Im Ausdruck (1) wurde vorstehend die Oberflächenvorhersage g(x) in Abhängigkeit einer Werkzeugfunktion k(x-y) definiert. Diese definiert die Wirkung des betreffenden Bearbeitungswerkzeugs 18 in Abhängigkeit vom Ort auf der Oberfläche 12. Gemäß einer Ausführungsform kann in der Werkzeugfunktion auch ein Verschleiß des Bearbeitungswerkzeugs berücksichtigt werden. So kann die Werkzeugfunktion eine Zeitabhängigkeit aufweisen, d.h. die Werkzeugfunktion ändert sich in Abhängigkeit von der Bearbeitungsdauer. Auch kann die Änderung der Werkzeugfunktion in Abhängigkeit von dem bisher erfolgten Bearbeitungsabtrag erfolgen. Weiterhin kann gemäß einer Ausführungsform die Werkzeugfunktion eine Ortsabhängigkeit aufweisen (z.B. geometrisch bedingte Variationen).

Im Ausdruck (2) sind $\lambda_j$ Nutzerparameter zu Steuerung der Glattheit der Lösung. Darunter sind die Gradienten der Aufenthaltsdauer $\tau(x)$ bei Übergang von Verweilort 34 zu Verweilort 34 zu verstehen. Gemäß einer Ausführungsvariante wird die Glattheit unter Berücksichtigung der Dynamik der einzelnen Bearbeitungswerkzeuge 18, d.h. der Maschinendynamik, beschränkt. Dabei können unterschiedliche Bewegungsachsen der Bearbeitungswerkzeuge 18 unterschiedliche Dynamik aufweisen. Die Beschränkung der Glattheit bzw. der Beschleunigung der Bearbeitungswerkzeuge oder anderer dynamischer Größen kann dementsprechend erfolgen.

In den vorstehend beschriebenen Ausführungsbeispielen erfolgt in jedem Bearbeitungsvorgang die Bearbeitung der Oberfläche 12 mit jeweils einem Bearbeitungswerkzeug 18. Gemäß einer weiteren Ausführungsvariante können in einem Bearbeitungsvorgang auch mehrere Bearbeitungswerkzeuge 18 gleichzeitig die Oberfläche 12 bearbeiten. Dies können mehrere Bearbeitungswerkzeuge der gleichen Art, beispielsweise drei computergesteuerte Poliereinrichtungen 18A, oder auch Bearbeitungswerkzeuge unterschiedlicher Art, beispielsweise eine Ionenstrahlbearbeitungseinrichtung 18B in Verbindung mit einer Elektronenstrahlbearbeitungseinrichtung 18C. In dieser Ausführungsvariante ist der Optimierungsalgorithmus vorteilhafterweise dazu konfiguriert, eine Kollision der Bearbeitungswerkzeuge 18 zu vermeiden.

Wie vorstehend erwähnt, kann der Optimierungsalgorithmus des Optimierungsproblems 60 dazu konfiguriert sein, Werkzeugparameter der verwendeten Bearbeitungswerkzeuge auszuwählen bzw. zu optimieren. Diese Werkzeugparameter können neben den vorstehend erwähnten Parametern (Linienbreite bzw. Werkzeuggröße) Parameter wie Betriebsalter des Werkzeugs, Anpressdruck, Ionenstrom, Elektronenstrom und/oder Pulsweitenmodulation umfassen. Mit einer Pulsweitenmodulation kann beispielsweise bei einer in einem gepulsten Modus betriebenen Ionenstrahlbearbeitungseinrichtung 18B vorgegeben werden, dass der Ionenstrahl 10% oder 20% der Zeit aktiv ist. Eine Variierung des Anpressdrucks etwa einer Polierscheibe einer computergesteuerten Poliereinrichtung kann mit der Aufenthaltsdauer abgeglichen werden. So kann etwa ein doppelter Anpressdruck eine verringerte Aufenthaltsdauer ermöglichen.

Gemäß einer weiteren Ausführungsvariante ist der Optimieralgorithmus des Optimierproblems 60 dazu konfiguriert, eine möglichst stabile Lösung für die Bearbeitung der Objektoberfläche aufzufinden. Darunter ist zu verstehen, dass vom Optimieralgorithmus eine Lösung, d.h. ein Bahnverlauf und eine Aufenthaltsdauerverteilung, gefunden wird, bei der kleine Veränderungen in der Arbeitsweise des Bearbeitungswerkzeugs 18 einen möglichst geringen Einfluss auf das Bearbeitungsergebnis haben. Unter einer Veränderung in der Arbeitsweise des Bearbeitungswerkzeugs ist beispielsweise ein Versatz oder eine Verdrehung der Polierscheibe einer Poliereinrichtung oder allgemein eine geringfügige Schwankung des Abtragsvolumens des Bearbeitungswerkzeugs zu verstehen. Im Ergebnis ermittelt der Optimieralgorithmus in dieser Ausführungsvariante ein Bearbeitungsrezept, das gegenüber Variationen der Bearbeitungswerkzeuge innerhalb eines Toleranzbereichs möglichst robust ist.

Die vorstehende Beschreibung beispielhafter Ausführungsbeispiele, Ausführungsformen bzw. Ausführungsvarianten ist exemplarisch zu verstehen. Die damit erfolgte Offenbarung ermöglicht es dem Fachmann einerseits, die vorliegende Erfindung und die damit verbundenen Vorteile zu verstehen, und umfasst andererseits im Verständnis des Fachmanns auch offensichtliche Abänderungen und Modifikationen der beschriebenen Strukturen und Verfahren. Daher sollen alle derartigen Abänderungen und Modifikationen, insoweit sie in den Rahmen der Erfindung gemäß der Definition in den beigefügten Ansprüchen fallen, sowie Äquivalente vom Schutz der Ansprüche abgedeckt sein.

Bezugszeichenliste

| | |
|---|---|
| 10 | Vorrichtung zum Verändern der Form einer Oberfläche |
| 12 | Oberfläche |
| 14 | Objekt |
| 16 | Formmanipulationseinrichtung |
| 18A | Bearbeitungswerkzeug in Gestalt einer computergesteuerten Poliereinrichtung |
| 18B | Bearbeitungswerkzeug in Gestalt einer Ionenstrahlbearbeitungseinrichtung |
| 18C | Bearbeitungswerkzeug in Gestalt einer Elektronenstrahlbearbeitungseinrichtung |
| 20 | Polierscheibe |
| 21 | Poliermittel |
| 22 | Motorspindel |
| 24 | Verschiebeeinheit |
| 26 | Ionenquelle |
| 28 | Beschleunigungseinheit |
| 30 | Ionenstrahl |
| 32 | Ablenkungseinheit |
| 34 | Verweilort |
| 36 | Elektronenstrahl |
| 38 | Elektronenquelle |
| 40 | Beschleunigungseinheit |
| 42 | Fokussierungseinheit |
| 44 | Ablenkungseinheit |
| 46 | Bahntyp |
| 50 | Steuerungseinrichtung |
| 52 | vorgegebene Solländerung h(x) |
| 56v | Vorgabe $\hat{\tau}_j(x)$ |
| 56 | Steuerungsgröße $\tau_j(x)$ |
| 58 | Oberflächenänderungsvorhersage g(x) |
| 60 | Optimierungsproblem |

62
    Vorabstartwert $\tau_j^{start1}$

64
    Startwert $\tau_j^{start2}$

66    Voraboptimierungsproblem

68    weiteres Voraboptimierungsproblem

## Patentansprüche

1. Vorrichtung (10) zum Verändern einer Form einer Oberfläche (12) eines Objekts (14) mit:

   - einer Formmanipulationseinrichtung (16), welche dazu konfiguriert ist, in mindestens zwei Bearbeitungsvorgängen in Abhängigkeit von einer Steuerungsgröße (56) eine Veränderung der Oberfläche des Objekts zu bewirken, wobei mindestens ein Abschnitt der Oberfläche in jedem der Bearbeitungsvorgänge bearbeitet wird, sowie
   - einer Steuerungseinrichtung (50), welche dazu konfiguriert ist, aus einer vorgegebenen Solländerung (52) der Oberflächenform des Objekts eine Vorgabe (56v) für die Steuerungsgröße (56) der Formmanipulationseinrichtung mittels einer Optimierung (60) zu ermitteln, bei der eine Gesamtzeit, welche zur Erzeugung der durch die mindestens zwei Bearbeitungsvorgänge erfolgenden Oberflächenänderung benötigt wird, minimiert wird.

2. Vorrichtung nach Anspruch 1,
   bei der die Formmanipulationseinrichtung (16) mehrere Bearbeitungswerkzeuge (18A, 18B, 18C) zur Veränderung der Oberfläche umfasst, wobei bei einem ersten der Bearbeitungsvorgänge ein erstes der Bearbeitungswerkzeuge und bei einem zweiten der Bearbeitungsvorgänge ein zweites der Bearbeitungswerkzeuge Verwendung findet.

3. Vorrichtung nach Anspruch 1 oder 2,
   bei der die Formmanipulationseinrichtung (16) mindestens ein Bearbeitungswerkzeug (18A) umfasst, wobei bei zwei Bearbeitungsvorgängen jeweils dasselbe Bearbeitungswerkzeug (18A) zum Einsatz kommt.

4. Vorrichtung nach Anspruch 2,
   bei der die Steuerungseinrichtung (50) dazu konfiguriert ist, bei der Optimierung für den jeweiligen Bearbeitungsvorgang ein jeweiliges Bearbeitungswerkzeug (18A, 18B, 18C) auszuwählen.

5. Vorrichtung nach einem der Ansprüche 2 bis 4,
   bei der die Steuerungseinrichtung (50) dazu konfiguriert ist, für die in den verschiedenen Bearbeitungsvorgängen zum Einsatz kommenden Bearbeitungswerkzeuge jeweils mindestens einen Werkzeugparameter zu optimieren.

6. Vorrichtung nach Anspruch 5,
   bei dem der optimierte Werkzeugparameter eine Bearbeitungsbreite des Bearbeitungswerkzeugs (18A, 18B, 18C) umfasst.

7. Vorrichtung nach einem der vorausgehenden Ansprüche,
   bei der die Steuerungseinrichtung (50) dazu konfiguriert ist, die Vorgabe für die Steuerungsgröße für mindestens drei Bearbeitungsvorgänge zu ermitteln.

8. Vorrichtung nach einem der vorausgehenden Ansprüche,
   wobei bei der Optimierung (60) die Ermittlung der Vorgabe (56v) für die Steuerungsgröße unter Berücksichtigung einer die Abweichung der Oberflächenänderung von der Solländerung (52) begrenzenden Nebenbedingung erfolgt.

9. Vorrichtung nach einem der vorausgehenden Ansprüche,
   bei der für jeden der Bearbeitungsvorgänge eine jeweilige Bearbeitungsbahn (46), entlang welcher die Bearbeitung der Oberfläche (12) des Objekts zu erfolgen hat, vorgegeben ist.

10. Vorrichtung nach einem der vorausgehenden Ansprüche,
    bei der die Steuerungseinrichtung (50) dazu konfiguriert ist, eine jeweilige optimierte Bearbeitungsbahn für den jeweiligen Bearbeitungsvorgang bei der Optimierung zu ermitteln.

**11.** Vorrichtung nach Anspruch 10,
bei der die Steuerungseinrichtung (50) dazu konfiguriert ist, die jeweilige optimierte Bearbeitungsbahn durch Auswahl aus einer vorgegebenen Gruppe an Bahntypen (46) zu bestimmen.

**12.** Vorrichtung nach Anspruch 10 oder 11,
bei der ein bei der Optimierung (60) verwendeter Startwert (64) für die Steuerungsgröße mittels einer Voraboptimierung (68) ermittelt wird, bei der Gradienten von Aufenthaltsdauern eines Bearbeitungswerkzeugs der jeweiligen Bearbeitungsbahn optimiert werden.

**13.** Vorrichtung nach einem der vorausgehenden Ansprüche,
welche dazu konfiguriert ist, eine Form einer Oberfläche eines optischen Elements einer Projektionsbelichtungsanlage für die Mikrolithographie an eine Sollform anzupassen.

**14.** Verfahren zum Verändern einer Form einer Oberfläche (12) eines Objekts (14), bei dem:

eine Vorgabe (56v) für eine Steuerungsgröße (56) einer Formmanipulationseinrichtung (16) aus einer vorgegebenen Solländerung (52) der Oberflächenform des Objekts mittels einer Optimierung (60) ermittelt wird,
wobei die Steuerungsgröße (56) zur Ausführung von mindestens zwei Bearbeitungsvorgängen mittels der Formmanipulationseinrichtung dient, in denen mindestens ein Abschnitt der Oberfläche in jedem der Bearbeitungsvorgänge bearbeitet wird, und
wobei bei der Optimierung eine Gesamtzeit, welche zur Erzeugung der durch die Bearbeitungsvorgänge erfolgenden Oberflächenänderung benötigt wird, minimiert wird.

Fig. 1

Fig. 2

$h(x)$ ~52

$$\underset{\tau_j}{\mathrm{argmin}} \int_{S_j} \tau_j(s) + \lambda_j |\dot{\tau}_j(s)|^2 \, ds$$

NB1: $\rho_j\left(h_{j-1} - g_{\tau_j}\right) < \delta_j$      NB2: $\tau_j \in T_j$

~66

$\tau_j^{\mathrm{start1}}$ ~62

$$\underset{\tau_1,\ldots,\tau_n}{\mathrm{argmin}} \left( \rho\left(h - \sum_{j=1}^{n} g_j\right)^2 + \alpha \sum_j R(\tau_j) \right)$$ ~68

$\tau_j^{\mathrm{start2}}$ ~64

$$\underset{\tau_1,\ldots,\tau_n}{\mathrm{argmin}} \sum_{j=1}^{n} \int_{S_j} \gamma_j \tau_j(s) + \lambda_j |\dot{\tau}_j(s)|^2 \, ds$$

NB1: $\rho\left(h - \sum_{j=1}^{n} g_{\tau_j}\right) < \delta_{\mathrm{spec}}$      NB2: $\tau_j \in T_j$

~60

$\hat{\tau}_j(x)$ ~56v

Fig. 3

# EUROPÄISCHER RECHERCHENBERICHT

Europäisches Patentamt
European Patent Office
Office européen des brevets

Nummer der Anmeldung

EP 25 18 3516

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2021 202502 B4 (ZEISS CARL SMT GMBH [DE]) 19. Januar 2023 (2023-01-19) | 1-3,7,8, 13,14 | INV. G05B19/40 |
| Y | * Zusammenfassung * * Absatz [0001] - Absatz [0055] * * Abbildung 1 * ----- | 4-6,9-12 | G05B19/418 H01J37/30 |
| Y | WANG HAN ET AL: "A two-stage optimization method for energy-saving flexible job-shop scheduling based on energy dynamic characterization", JOURNAL OF CLEANER PRODUCTION, ELSEVIER, AMSTERDAM, NL, Bd. 188, 27. März 2018 (2018-03-27), Seiten 575-588, XP085385989, ISSN: 0959-6526, DOI: 10.1016/J.JCLEPRO.2018.03.254 | 4-6 | |
| A | * Zusammenfassung * * Abschnitt 2.3 * * Abbildung 1 * ----- | 1-3,7-14 | |
| Y | DE 10 2022 208269 A1 (ZEISS CARL SMT GMBH [DE]) 28. September 2023 (2023-09-28) | 9-12 | **RECHERCHIERTE SACHGEBIETE (IPC)** |
| A | * Zusammenfassung * * Absatz [0010] - Absatz [0030] * * Absatz [0068] - Absatz [0082] * * Abbildung 1 * ----- | 1-8,13, 14 | G05B |
| A | EP 3 309 635 A1 (SIEMENS AG [DE]) 18. April 2018 (2018-04-18) * Zusammenfassung * * Absatz [0010] - Absatz [0012] * * Absatz [0029] - Absatz [0032] * * Absatz [0039] * ----- | 1-14 | |
| A | JP H01 228755 A (FANUC LTD) 12. September 1989 (1989-09-12) * das ganze Dokument * ----- | 1-14 | |

Der vorliegende Recherchenbericht wurde für alle Patentansprüche erstellt

| Recherchenort | Abschlußdatum der Recherche | Prüfer |
|---|---|---|
| Den Haag | 30. Oktober 2025 | Kielhöfer, Patrick |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
..........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 25 18 3516

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-10-2025

| Im Recherchenbericht angeführtes Patentdokument | Datum der Veröffentlichung | Mitglied(er) der Patentfamilie | Datum der Veröffentlichung |
|---|---|---|---|
| DE 102021202502 B4 | 19-01-2023 | KEINE | |
| DE 102022208269 A1 | 28-09-2023 | KEINE | |
| EP 3309635 A1 | 18-04-2018 | KEINE | |
| JP H01228755 A | 12-09-1989 | KEINE | |

EPO FORM P0461

Für nähere Einzelheiten zu diesem Anhang : siehe Amtsblatt des Europäischen Patentamts, Nr.12/82

**EP 4 682 656 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102024206637

- DE 102012212199 A1